# EUROPEAN PATENT APPLICATION

(11) **EP 1 308 417 A2**
(43) Date of publication of application: **07.05.2003**
(21) Application number: 02024563.5
(22) Date of filing: 04.11.2002
(51) Int. Cl.: C01G 1/02, C01G 3/00, C01G 9/02, C01G 11/00, C01G 15/00

(54) **Method and apparatus for producing metal oxide**

(30) Priority: 02.11.2001 JP 2001338006
(71) Applicant: Rigaku Corporation, Akishima-shi, Tokyo 196-8666 (JP)
(72) Inventor: Arii, Tadashi, Fussa-shi, Tokyo 197-0011 (JP); Kishi, Akira, Hachiouji-shi, Tokyo 192-0364 (JP)
(74) Representative: Wagner, Karl H., Dipl.-Ing.

(57) **Abstract**

Metal oxide is produced by heating a metal salt of a carboxylic acid to a predetermined temperature, which varies with a raw material, lower than 300 °C. In the case of using zinc acetate as the raw material, when heated in dry helium gas, it is sublimated and decomposed to produce no zinc oxide. In contrast, when heated in a mixture gas of nitrogen gas and water vapor with a programming rate of 5 °C/min, the weight loss begins around 110 °C and has been completed around 230 °C, at a water vapor partial pressure of 17.9 kPa, to produce zinc oxide. If keeping the temperature approximately constant when the weight loss begins, zinc oxide is produced around 115 °C with a high degree of crystallinity. A metal may be any one of zinc, cadmium, indium and copper. A carboxylic acid may be any one of formic acid, acetic acid, propionic acid and 2-ethylhexanoic acid.

## Description

### BACKGROUND OF THE INVENTION

This invention relates to a method for producing a metal oxide, and especially to a method for producing a metal oxide at a temperature lower than that in the conventional method with the use of a metal salt of a carboxylic acid as a raw material and apparatus for producing such a metal oxide. This invention further relates to a semiconductor device having such a metal oxide produced by such a method.

There has been a strong need for producing a metal oxide thin film for an electronic use at the lowest temperature possible and at high efficiency. Accordingly, various methods have been investigated. The typical methods for producing a metal oxide thin film can be roughly classified to first a coating method including a sol-gel process and an MOD (Metallo-Organic Decomposition) process, and second a vapor deposition method including a CVD (Chemical Vapor Deposition) process and a sputtering process. Of these processes, the sol-gel process, the MOD process and the CVD process have been developed and put to practical use for the mass production.

In the CVD process, an organometallic compound, a metal complex or a metal alkoxide may be used as a raw material. An ideal raw material for the CVD must satisfy the requirements : (1) with a high vapor pressure at a low temperature, (2) less poisonous, and (3) able to maintain a stable vapor pressure for a long time. There are no many materials satisfying the requirements. Especially, there are very few materials with a high vapor pressure at a low temperature. Explaining the vapor pressure requirement of the raw material, the CVD process makes the raw material sublimate or vaporize and uses vapor-phase precursor molecules. Therefore, materials with a low vapor pressure can not be used as raw materials in the CVD process because they can not become a vapor phase. Further, the CVD process often requires a temperature higher than 500 °C for producing a thin film with a high degree of crystallinity. Furthermore, the vapor deposition method including the CVD process requires expensive vacuum equipment and exhaust equipment.

Next, explaining the sol-gel process and the MOD process, they have the steps of: coating a substrate with a raw material solution; removing an organic solvent by heating; removing organic ingredients; calcining; and annealing for crystallization to produce a metal oxide. Of these steps, the removing step of organic ingredients, i.e., a step of thermal decomposition, often requires a temperature higher than 300 °C. Besides, the annealing step often requires a temperature higher than 500 °C because the product by only the step of removing organic ingredients would have a low degree of crystallinity.

The present invention is intended to produce metal oxide with a high degree of cystallinity with the use of a metal salt of a carboxylic acid as a raw material at a temperature lower than that in the conventional method. The prior art most relevant to this invention is, so long as the inventors know, disclosed in Japanese Patent Publication 10-41485 A (1998). This prior art method has the steps of: coating a substrate with a metal-containing polyacid peroxide solution; and heating it to a range between 350 and 400 °C in an atmosphere of water vapor to produce a metal oxide thin film.

The conventional method with the use of a metal-containing polyacid peroxide as a raw material, however, has the following problems. (1) The raw material is rare. A metal-containing polyacid peroxide is not so popular. This material can be produced, according to the description of the above-mentioned patent publication, by the steps of, for example, dissolving titaniumpowder in a hydrogen peroxide solution, decomposing excess hydrogen peroxide with the use of platinum catalyst, and filtering it to obtain a titanium-containing polyacid peroxide solution. Then, five parts by volume of ethyl cellosolve are added to one part by volume of the obtained solution to make a coating solution. (2) According to Table 1 of the patent publication, twenty-four kinds of metal oxide are produced at a production temperature of 350 °C or 400 °C. This production temperature is lower than that in the conventional coating method. However, there has been a strong need for producing a metal oxide at a much lower temperature.

### SUMMARY OF THE INVENTION

It is an object of the present invention to provide a method for producing a metal oxide at a temperature much lower than that in the conventional coating method.

It is another object of the present invention to provide a method for producing a metal oxide at a low temperature with the use of a metal salt of a carboxylic acid, which is used usually in a MOCVD process and thus a popular material, as a raw material.

A method for producing a metal oxide according to the present invention comprises a step of heating a metal salt of a carboxylic acid in an atmosphere of water vapor. A metal salt of a carboxylic acid may be hydrate or anhydride and may be heated in a powder state or in an on-a-substrate state which is made by the process that the metal salt is dissolved in a solution and then applied to a substrate. A method of the present invention can produce a metal oxide with a high degree of crystallinity at a much lower temperature than that in the conventional coating method. According to experiments for various materials, a metal oxide with a high degree of crystallinity can be obtained by heating a raw material to a predetermined temperature, which varies with a raw material, lower than 300 °C. With some different combinations of the kind of metal and the kind of carboxylic acid, a metal oxide with a high degree of crystallinity can be produced at a low temperature of about 115 °C or about 200 °C. Accordingly, a metal oxide with a high degree of crystallinity can be produced by heating the raw material to the predetermined temperature, which varies with a raw material and is lower than 300 °C for all tested metal salts of carboxylic acids.

A metal may be any one of zinc, cadmium, indium and copper. A carboxylic acid may be any one of formic acid, acetic acid, propionic acid and 2-ethylhexanoic acid. Many combinations of metals and carboxylic acids may be thought up with the use of various materials other than that mentioned above and they would be expected to be able to obtain a metal oxide at a temperature below 300 °C. A water vapor partial pressure in an atmosphere of water vapor may be within a range between 6 and 18 kPa. The atmosphere of water vapor may consist of preferably an inert gas (e.g., nitrogen, helium or argon) and water vapor.

A metal oxide with a high degree of crystallinity, which has been produced by a coating method at a low temperature, would be very useful, in semiconductor devices, for various insulator layers or dielectric layers, e.g., for a capacitor. Especially in view of mass productivity and less damage to semiconductor because of a low production temperature, the metal oxide production method according to the invention would be useful in the semiconductor production process.

Apparatus for producing a metal oxide according to the present invention comprises: (a) coating equipment for coating a substrate with a solution of a metal salt of a carboxylic acid, e.g., a spin coater; (b) a water vapor generator for generating a water-vapor-containing gas with a desired water vapor partial pressure; and (c) heating equipment for heating the substrate, which has been processed by the coating equipment, to a predetermined temperature in an atmosphere of the water-vapor-containing gas introduced from the water vapor generator. Alternatively, apparatus for producing a metal oxide according to the present invention may comprise: (a) a water vapor generator for generating a water-vapor-containing gas with a desired water vapor partial pressure; and (b) heating equipment for heating a metal salt of a carboxylic acid, which has been put in a sample vessel, to a predetermined temperature in an atmosphere of the water-vapor-containing gas introduced from the water vapor generator.

The heating equipment may be combined with any one or more units selected from a group consisting of (a) a unit for X-ray diffraction analysis (XRD) of a metal salt of a carboxylic acid and its derivatives, (b) a unit for differential thermal analysis (DTA) of a metal salt of a carboxylic acid and its derivatives, (c) a unit for differential scanning calorimetric analysis (DSC) of a metal salt of a carboxylic acid and its derivatives, and (d) a unit for thermogravimetric analysis (TG) of a metal salt of a carboxylic acid and its derivatives. With the use of one or more of these units, a metal oxide generating process can be observed in situ and thus the production of a metal oxide can be ascertained in situ.

The heating equipment may preferably include a constant temperature device for maintaining an inner wall surface temperature of the heating equipment at a desired value higher than the room temperature, for example, 60 °C, so as to prevent dew condensation of the water vapor on the inner wall surface of the heating equipment.

### BRIEF DESCRIPTION OF THE DRAWINGS

FIG. 1 illustrates the configuration of an embodiment of a system for carrying out a production method according to the present invention;
FIG. 2 illustrates the configuration of another embodiment of a system for carrying out a production method according to the present invention;
FIG. 3 illustrates a graph showing TG-DTA data of a heating experiment on zinc acetate dihydrate in a dry helium gas;
FIG. 4 illustrates a graph showing TG-DTA data of a heating experiment on zinc acetate dihydrate in an atmosphere of water vapor;
FIG. 5 illustrates a graph comparing a TG curve in FIG.3 with a TG curve in FIG. 4 in the same coordinate axes;
FIG. 6 illustrates graphs showing XRD-DSC data of a heating experiment on zinc acetate dihydrate in an atmosphere of water vapor; and
FIG. 7 illustrates a graph showing TG data of a heating experiment on zinc acetate dihydrate with a variable programming rate so as to make a weight loss rate constant.

### DETAILED DESCRIPTION OF THE PREFERRED EMBODIMENTS

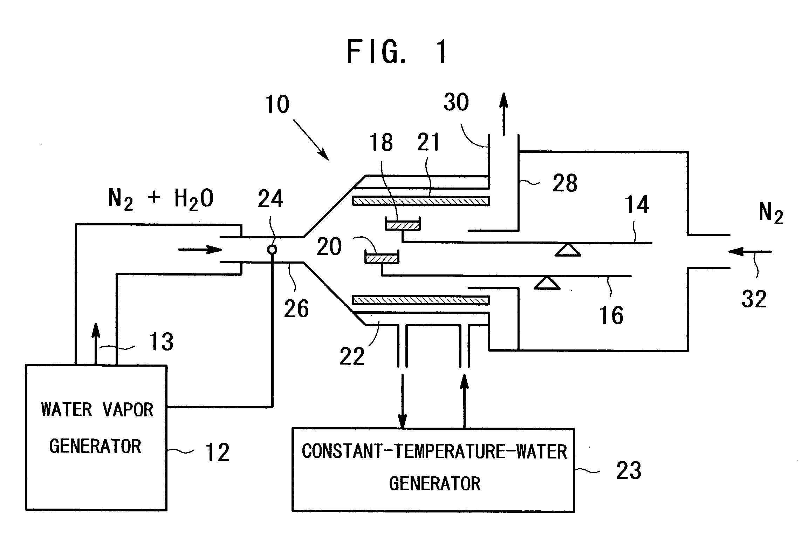

Referring to FIG. 1, this apparatus is comprised of heating equipment 10 and a water vapor generator 12. The heating equipment 10 is combined with a thermobalance or thermogravimetric analyzer and a differential thermal analyzer. The water vapor generator 12 can mix an inert gas (e.g. , nitrogen, argon or helium) , which is used as a carrier gas, with water vapor to generate a water-vapor-containing gas 13 with a desired water vapor partial pressure. The detailed structure of the water vapor generating equipment 12 may be that disclosed in, for example, Japanese Patent Publication 6-254415 A (1994) and Japanese Patent Publication 6-254416 A (1994).

The heating equipment 10 includes a differential, horizontal thermobalance which has two balance beams 14 and 16 having front ends on which a sample vessel for a reference sample 18 and another sample vessel for a measuring sample 20 are placed. The temperatures of the reference sample 18 and the measuring sample 20 can be sensed to obtain a temperature difference therebetween for a differential thermal analysis. The detailed structure of a combination of the differential, horizontal thermobalance and the differential thermal analyzer may be that disclosed in, for example, Japanese Patent Publication 8-184545 A (1996).

The reference sample 18 and the measuring sample 20 in the heating equipment 10 are heated with a heat source 21, for example, an infrared heater or a resistance heater, and their temperatures are controlled to be a desired value. The heating equipment 10 has a wall on which a jacket 22 is formed, the jacket 22 receiving constant-temperature water from a constant-temperature-water supply 23, so that the inner wall surface temperature of the heating equipment 10 can be maintained at a desired constant temperature, for example, 60 °C. The use of the constant temperature device prevents dew condensation of water vapor on the inner wall surface of the heating equipment 10.

Next, a method for controlling an atmosphere of water vapor in the heating equipment 10 will be explained. The water vapor generator 12 is connected with the heating equipment 10 via a joint pipe 26 inside which a humidity sensor 24 is arranged, the signal of the humidity sensor 24 being transferred to the water vapor generator 12 for a feedback control. The water vapor generator 12 can control the flow rate of a mixture gas 13 consisting of a carrier gas and water vapor, the relative humidity of the water vapor in the mixture gas 13 and the temperature of the mixture gas 13. For example, the flow rate of the mixture gas 13 may be set to a desired value within a range between 100 and 200 cc/min and the relative humidity at 60 °C may be regulated within a range between 20 and 90 percent. Incidentally, using a water vapor partial pressure is more pertinent than using a relative humidity in considering the absolute amount of water in the atmosphere of water vapor. The relative humidity can be converted to the water vapor partial pressure, for example, a relative humidity of 90 percent at 60 °C is converted to a water vapor partial pressure of 17.9 kPa.

The pressure inside the heating equipment 10 is an ambient pressure and the water-vapor-containing gas 13 is introduced from the joint pipe 26 into the inside of the heating equipment 10. The introduced gas is exhausted from an outlet 30 to the outside, the outlet 30 being arranged in front of a partition 28. The partition 28 has a central portion formed with a through hole through which the two balance beams 14 and 16 pass. On the other hand, a curtain gas 32 (an inert gas such as nitrogen) may be introduced into the inside of the heating equipment 10 from the end of the measurement-system side (the right side in FIG. 1) of the thermobalance, the curtain gas 32 passing through the through hole of the partition 28 and being exhausted from the outlet 30 to the outside. With the use of the partition 28 and the curtain gas 32, the water-vapor-containing gas 13 is prevented from entering into the measurement system and thus the water vapor is prevented from affecting the measurement system.

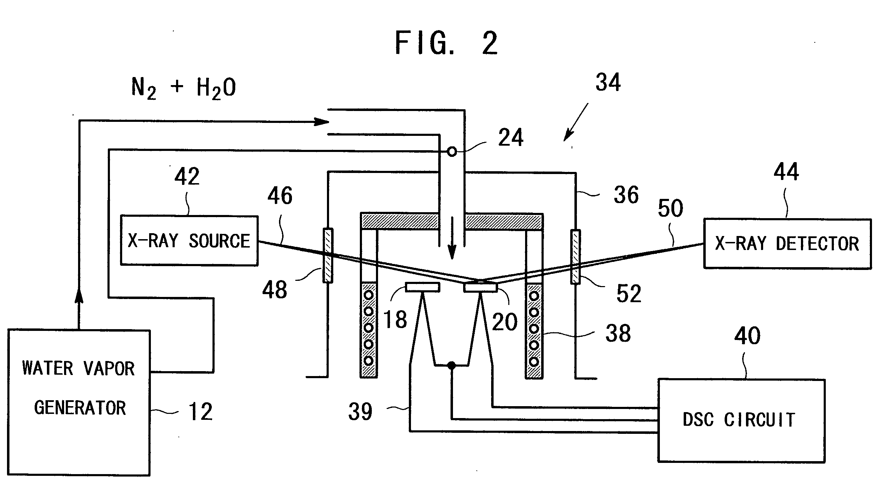

Next, another apparatus for producing a metal oxide will be explained. Referring to FIG. 2, this apparatus is comprised of heating equipment 34 and the water vapor generator 12. The heating equipment 34 is combined with an X-ray diffraction analyzer and a differential scanning calorimeter. The water vapor generator 12 and the humidity sensor 24 are the same as those shown in FIG. 1. The heating equipment 34 has a cover 36 inside which a heating furnace 38 is arranged. The reference sample 18 and the measuring sample 20 are disposed in the heating furnace 38. The temperatures of the reference sample 18 and the measuring sample 20 are sensed by a thermocouple 39 and its signal is transferred to the DSC circuit 40. With the differential scanning calorimeter, the thermal variation of the measuring sample 20 can be sensed as a calorie for compensating the thermal variation. On the other hand, the X-ray diffraction analyzer can measure X-ray diffraction patterns of the measuring sample 20, the X-ray diffraction analyzer having an X-ray source 42 , an X-ray detector 44 and a goniometer for rotating them with a predetermined angular relationship. X-rays 46 from the X-ray source 42 pass through an X-ray window 48 mounted on the cover 36 and are incident upon the surface of the measuring sample 20. X-rays 50 diffracted from the surface of the measuring sample 20 pass through another X-ray window 52 and are then detected by the X-ray detector 44. The detailed structure of a combination of the X-ray diffraction analyzer and the differential scanning calorimeter may be that disclosed in, for example, Japanese Patent Publication 10-19815 A (1998) and Japanese Patent Publication 11-132977 A (1999).

Next, the detailed condition and the measured result will be explained in producing a metal oxide with the use of a metal salt of a carboxylic acid as a raw material. In the all experiments described below, metal salts of carboxylic acids were heated in the powder state, but alternatively they may be dissolved in a solution and then applied to a substrate which is thereafter heated to form a metal oxide thin film on the substrate.

### [Comparative Example]

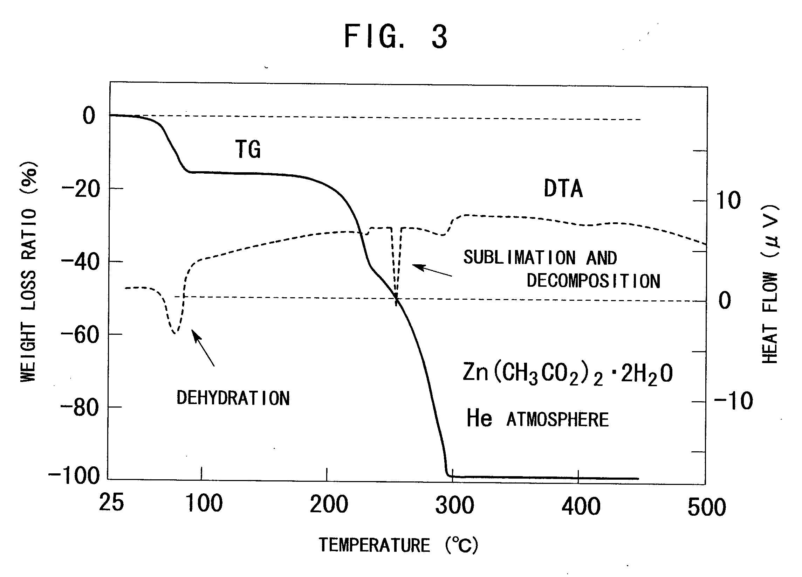

First, there will be explained a comparative example in which the raw material is heated in an atmosphere of an inert gas which includes no water vapor. In the apparatus shown in FIG. 1, zinc acetate dihydrate, Zn(CH₃CO₂)₂ · 2H₂O, was used as the measuring sample and heated in an atmosphere of dry helium gas under the condition that: 5.7 mg zinc acetate dihydrate powder was put in a sample vessel made of aluminum with a diameter of 5 mm and a depth of 2.5 mm and heated with a programming rate of 5 °C/min. The result is shown in FIG. 3, in which the curve denoted with TG indicates the result of the thermogravimetric analysis which measures the weight loss of the measuring sample. The curve denoted with DTA indicates the result of the differential thermal analysis. There can be seen from the curves the following phenomena. In the TG curve, the weight loss begins around 90 °C , which is considered to be caused by sublimation and decomposition, and thereafter almost all amount of the raw material has been decomposed at 300 °C and it disappears, becoming a vapor phase. In the DTA curve, an endoergic reaction appears around 70 to 80 °C, which is considered to be caused by dehydration, and another acute endoergic reaction appears around 260 °C, which is considered to be caused by sublimation and decomposition. Accordingly, it is understood that the zinc acetate supplied as a raw material has disappeared because of sublimation and decomposition and no zinc oxide was produced.

### [Example 1]

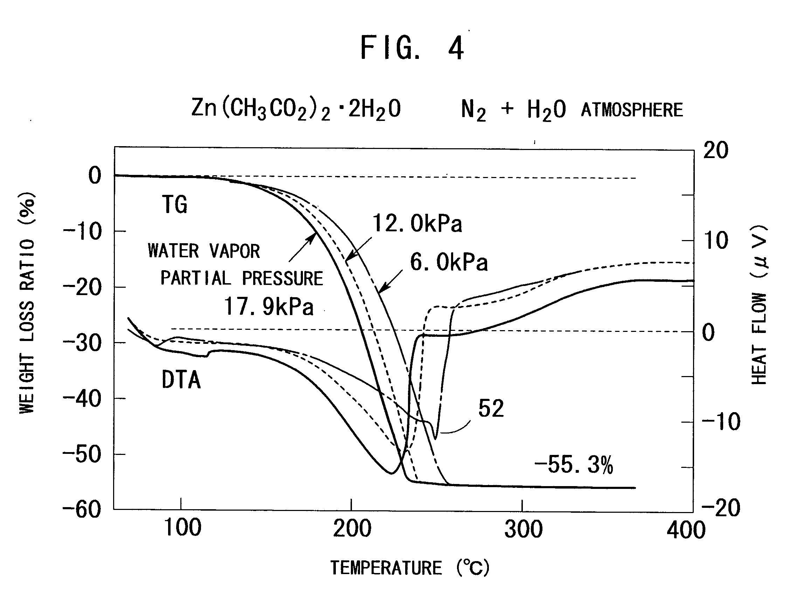

In the apparatus shown in FIG. 1, zinc acetate dihydrate was used as the raw material and heated in an atmosphere of water vapor under the condition that: 8.6 to 9.7 mg zinc acetate dihydrate powder was put in a sample vessel made of aluminum with a diameter of 5 mm and a depth of 2.5 mm and heated with a programming rate of 5 °C/min. The result is shown in FIG. 4. Three kinds of water vapor partial pressure were used: the relative humidity of 90 percent (water vapor partial pressure of 17.9 kPa), 60 percent (12.0 kPa) and 30 percent (6.0 kPa) all at 60 °C with the use of nitrogen gas as a carrier gas. The amount of the measuring sample was 9.7 mg for 90 percent, 9.5 mg for 60 percent and 8.6 mg for 30 percent. There can be seen from the curves the following phenomena. The weight loss begins around 110 °C at any water vapor partial pressure. The weight loss has been completed around 230 °C at 17.9 kPa, around 240 °C at 12.0 kPa and around 260 °C at 6.0 kPa. The final weight loss ratios for the three conditions became the same, 55.3 percent, which is approximately identical with the theoretical weight loss ratio of 55.6 percent with which zinc oxide (ZnO) has been ideally produced. Accordingly, it is understood that the raw material has been consumed to change to zinc oxide with no sublimation. It was reliably ascertained that, with the X-ray diffraction analysis described below, the product was zinc oxide.

Incidentally, a small endoergic reaction 52 appears around 250 °C in the DTA curve only for 6.0 kPa, which is considered to be caused by sublimation and decomposition. Therefore, it would be considered that the lower limit of the water vapor partial pressure required for producing a metal oxide would be around 6 kPa.

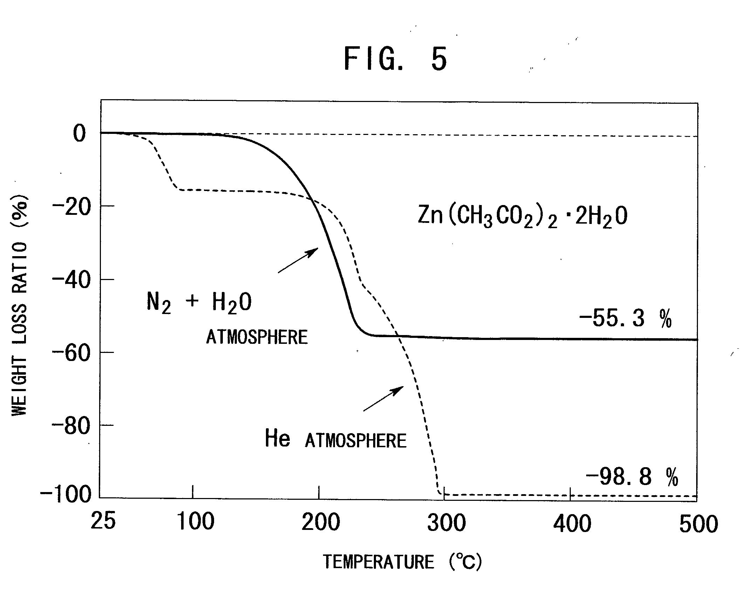

Referring to FIG. 5 showing comparison between the TG curve in FIG. 3 (heating in a dry helium gas) and the TG curve for 17.9 kPa in FIG. 4 (heating in water vapor), it is readily understood that the weight loss curves are different from each other. In an atmosphere of the dry gas almost all amount of the raw material has been sublimated, whereas in an atmosphere of the water vapor all amount of the raw material has changed to zinc oxide.

### [Example 2]

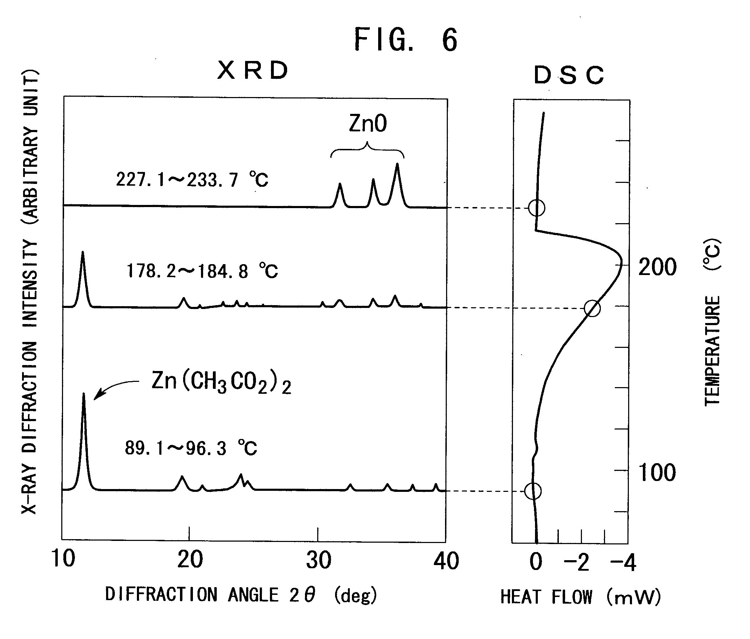

In the apparatus shown in FIG. 2, zinc acetate dihydrate was used as the raw material and heated in an atmosphere of water vapor under the condition that: about 10 mg zinc acetate dihydrate powder was put in a sample vessel made of aluminum with a 7-mm-square cross-section and a depth of 0.2 mm and heated with a programming rate of 4 °C/min in an atmosphere of nitrogen gas and water vapor with a water vapor partial pressure of 6.4 kPa. The result is shown in FIG. 6. The graph on the right side in FIG. 6 shows the DSC data, while the graphs on the left side show the XRD data. Three X-ray diffraction patterns correspond to the temperatures marked with white circles on the DSC curve. The X-ray diffraction patterns were measured with the condition that X-rays were CuKα and the scanning speed of the diffraction angle 2θ was twenty angular degrees per minute. It is noted that although many X-ray diffraction patterns were measured at the interval of 6 to 7 °C during the temperature rise, FIG. 6 shows only three patterns of these many patterns. The technique of comparing the DSC curve with the X-ray diffraction patterns as shown in FIG. 6 is disclosed in detail in Japanese Patent Publication 11-295244 A (1999).

There can be seen from the curves in FIG. 6 the following phenomena. In the DSC curve, an endoergic reaction begins around above 110 °C and has been completed around 220 °C. Referring to the X-ray diffraction patterns corresponding to the DSC curve, the diffraction peaks of zinc acetate appear before the beginning of the endoergic reaction. The intensities of the diffraction peaks of zinc acetate are going down during the endoergic reaction, while the intensities of the diffraction peaks of zinc oxide (ZnO) are going up. Finally, only the diffraction peaks of zinc oxide appear above 220 °C at which the endoergic reaction has been completed. Accordingly, it is understood that the raw material has changed to zinc oxide at all at 220 °C, the diffraction peaks of zinc oxide being sharp and intensive which indicates the degree of crystallinity of zinc oxide is good.

### [Example 3]

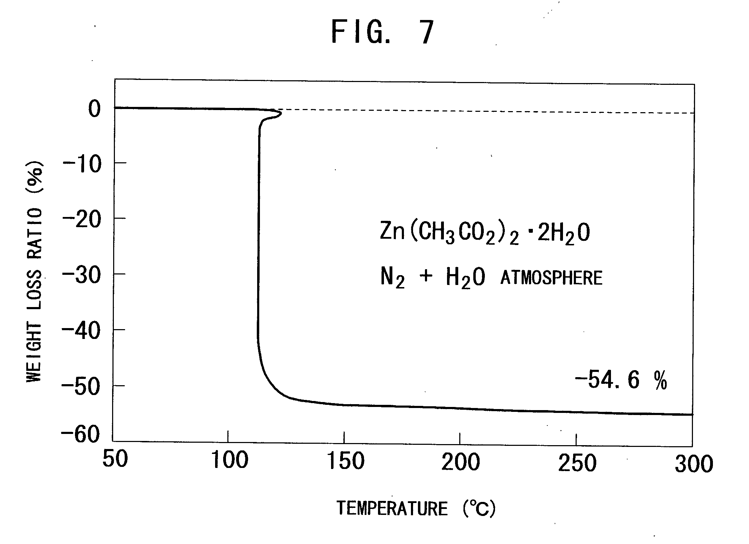

In the apparatus shown in FIG. 1, zinc acetate dihydrate was used as the raw material and heated under the condition that: 10 mg zinc acetate dihydrate powder was put in a sample vessel made of aluminum with a diameter of 5 mm and a depth of 2.5 mm and heated in an atmosphere of nitrogen gas and water vapor with a water vapor partial pressure of 17.9 kPa with a variable programming rate so as to make a weight loss rate constant, noting that the maximum programming rate is set to 5°C/min. The result is shown in FIG. 7. Another similar measurement was also carried out for a water vapor partial pressure of 12.0 kPa, its result being almost the same as the graph in FIG. 7. The technique of heating the sample so as to make a weight loss rate constant in the thermogravimetric analysis is disclosed in detail in, for example, Japanese Patent Publication 11-23442 A (1999).

There can be seen from the curve in FIG. 7 the following phenomena . When making the weight loss rate constant, the weight loss has been completed around 115 °C, which was very low, and the final weight loss became 54. 6 percent, which was approximately identical with the theoretical weight loss ratio of 55.6 percent with which zinc oxide has been ideally produced. Accordingly, it is understood that zinc oxide was produced. Comparing with the curve in FIG. 3 (a constant programming rate), the production of zinc oxide in FIG. 7 has been completed at a very low temperature, which can be construed as described below. In the curves in FIG. 3, since the programming rate is kept constant even' after the beginning of the change from zinc acetate to zinc oxide, the temperature is going up during the production of zinc oxide. Therefore, as shown in FIG. 4, the lower the water vapor partial pressure (i.e., the less the water vapor), the higher the temperature at which the production of zinc oxide has been completed. On the other hand, in FIG. 7, when the raw material begins to change to zinc oxide (i.e., the weight loss begins), the temperature rise becomes very slowly (its rate might become minus in the extreme case) , so that the reaction progresses under the condition of keeping the temperature of the raw material almost constant. Therefore, there appears in the graph the intrinsic temperature at which the raw material changes to zinc oxide, the intrinsic temperature being 115 °C. It is presumed that zinc acetate would be decomposed to zinc oxide under catalytic activity of water vapor. If not for analysis of the reaction behavior but for only the production of zinc oxide, the temperature of the raw material may be increased to above 115 °C and kept at this temperature, so that zinc oxide can be produced from zinc acetate.

### [Example 4]

In the apparatus shown in FIG. 1, cadmium acetate dehydrate, Cd(CH₃CO₂)₂ · 2H₂O, was used as the raw material and heated under the condition that: 14.3 mg cadmium acetate dihydrate powder was put in a sample vessel made of aluminum with a diameter of 5 mm and a depth of 2.5 mm and heated with a programming rate of 5 °C/min in an atmosphere of nitrogen gas and water vapor with a water vapor partial pressure of 12.0 kPa. As a result, although a graph is not shown, the weight loss begins around 200 °C and has been completed around 300 °C, the final weight loss ratio being 51.8 percent which is identical with the theoretical weight loss ratio of 51.8 percent with which cadmium oxide (CdO) has been ideally produced. Accordingly, it is ascertained that cadmium oxide has been produced. Further, the cadmium acetate was heated in also the other apparatus shown in FIG. 2, and it was ascertained also that the diffraction peaks of cadmium oxide appear in the X-ray diffraction patterns above around 200 °C. Therefore, it is understood that if cadmium acetate dihydrate is heated to above 200 °C and kept at this temperature in an atmosphere of water vapor, cadmium oxide can be produced.

### [Example 5]

In the apparatus shown in FIG. 1, copper acetate anhydride, Cu(CH₃CO₂)₂, was used as the raw material and heated under the condition that: 7.9 mg copper acetate powder was put in a sample vessel made of aluminum with a diameter of 5 mm and a depth of 2.5 mm and heated with a programming rate of 5 °C/min in an atmosphere of nitrogen gas and water vapor with a water vapor partial pressure of 12.0 kPa. As a result, although a graph is not shown, the weight loss begins around 160 °C and has been completed around 220 °C, the final weight loss ratio being 56.8 percent which is approximately identical with the theoretical weight loss ratio of 56.2 percent with which copper oxide (CuO) has been ideally produced. Accordingly, it is ascertained that copper oxide has been produced. Further, the copper acetate was heated in also the other apparatus shown in FIG. 2, and it was ascertained also that the diffraction peaks of copper oxide appear in the X-ray diffraction patterns above around 160 °C. Therefore, it is understood that if copper acetate anhydride is heated to above 160 °C and kept at this temperature in an atmosphere of water vapor, copper oxide can be produced.

### [Example 6]

In the apparatus shown in FIG. 2, indium formate was used as the raw material and heated under the condition that: 8.2 mg indium formate powder was put in a sample vessel made of aluminum with a 7-mm-square cross-section and a depth of 0.25 mm and heated with a programming rate of 5 °C/min in an atmosphere of nitrogen gas and water vapor with an about 10 percent relative humidity at 100 °C . As a result, although a graph is not shown, a large endoergic reaction appeared around 210 °C and the diffraction peaks of indium oxide (In₂O₃) appeared above this temperature. Accordingly, it is ascertained that indium oxide can be produced at 210 °C, noting that if the temperature is kept constant, indium oxide could be produced at a certain temperature lower than 210 °C.

### [Example 7]

In the apparatus shown in FIG. 2, indium acetate was used as the raw material and heated under the condition that: 8.1 mg indium acetate powder was put in a sample vessel made of aluminum with a 7-mm-square cross-section and a depth of 0.25 mm and heated with a programming rate of 5 °C/min in an atmosphere of nitrogen gas and water vapor with an about 10 percent relative humidity at 100 °C . As a result, although a graph is not shown, a large endoergic reaction appeared around 190 °C and the diffraction peaks of indium oxide (In₂O₃) appeared above this temperature. Accordingly, it is ascertained that indium oxide can be produced at 190 °C, noting that if the temperature is kept constant, indium oxide could be produced at a certain temperature lower than 190 °C.

### [Example 8]

In the apparatus shown in FIG. 2, indium propionate was used as the raw material and heated under the condition that: 10.9 mg indium propionate powder was put in a sample vessel made of aluminum with a 7-mm-square cross-section and a depth of 0.25 mm and heated with a programming rate of 5 °C/min in an atmosphere of nitrogen gas and water vapor with an about 10 percent relative humidity at 100 °C. As a result, although a graph is not shown, a large endoergic reaction appeared around 190 °C and the diffraction peaks of indium oxide (In₂O₃) appeared above this temperature. Accordingly, it is ascertained that indium oxide can be produced at 190 °C, noting that if the temperature is kept constant, indium oxide could be produced at a certain temperature lower than 190 °C.

### [Example 9]

In the apparatus shown in FIG. 2, indium 2-ethylhexanoate was used as the raw material and heated under the condition that: 10.2 mg indium 2-ethylhexanoate powder was put in a sample vessel made of aluminum with a 7-mm-square cross-section and a depth of 0.25 mm and heated with a programming rate of 5 °C/min in an atmosphere of nitrogen gas and water vapor with an about 10 percent relative humidity at 100 °C. As a result, although a graph is not shown, a large endoergic reaction appeared around 240 °C and the diffraction peaks of indium oxide (In₂O₃) appeared above this temperature. Accordingly, it is ascertained that indium oxide can be produced at 240 °C, noting that if the temperature is kept constant, indium oxide could be produced at a certain temperature lower than 240 °C.

All the raw materials used in Examples 6 to 9 are anhydride. It is ascertained that, in connection with Examples 6 to 9, the indium oxide produced from indium formate shows sharp and most intensive diffraction peaks and the highest degree of crystallinity. It is also ascertained that the larger the molecular weight of the functional group connected to indium as in the order of indium acetate, indium propionate and indium 2-ethylhexanoate, the lower the degree of crystallinity of the produced indium oxide.

Although the raw material power was heated as it was in the all experiments described above, a coating method may be used alternatively. That is, a thin film of metal oxide can be produced with the use of the coating method as described below. Explaining the case of using indium 2-ethylhexanoate as the raw material, at first it is dissolved in 2-ethylhexanoic acid with a concentration lower than 10 percent to make a raw material solution. If using zinc acetate or cadmium acetate, it is dissolved in acetic acid. Next, the raw material solution is applied to a substrate with the use of a spin coating method or a dip coating method. Then, the substrate coated with the raw material solution is placed on a heater plate in the heating equipment and water vapor is introduced into the inside of the heating equipment with a predetermined partial pressure of water vapor with the use of inert gas as a carrier gas, for example, nitrogen, argon or helium. In such an atmosphere, the substrate is heated, with a temperature control device, with a predetermined programming rate to a predetermined temperature, around 240 °C for indium 2-ethylhexanoate, lower than 300 °C, so that a thin film of indium oxide can be formed.
- 10 ···: heating equipment
- 12 ···: water vapor generator
- 13 ···: water-vapor-containing gas
- 14, 16 ···: balance beam
- 18 ···: reference sample
- 20 ···: measuring sample
- 21 ···: heat source
- 22 ···: jacket
- 23 ···: constant-temperature-water supply
- 24 ···: humidity sensor
- 26 ···: joint pipe
- 28 ···: partition
- 30 ···: outlet
- 32 ···: curtain gas
- 34 ···: heating equipment
- 36 ···: cover
- 38 ···: heating furnace
- 39 ···: thermocouple
- 40 ···: DSC circuit
- 42 ···: X-ray source
- 44 ···: X-ray detector
- 48, 52 ···: X-ray window

## Claims

1. A method for producing metal oxide comprising a step of heating a metal salt of a carboxylic acid in an atmosphere of water vapor.

2. A method according to claim 1, wherein said metal salt of said carboxylic acid is heated to a predetermined temperature below 300 °C.

3. A method according to claim 2, wherein a solution of said metal salt of said carboxylic acid is applied to a substrate to form a thin film of metal oxide on said substrate.

4. A method according to claim 1, wherein said metal is any one of zinc, cadmium, indium and copper.

5. A method according to claim 4, wherein said carboxylic acid is any one of formic acid, acetic acid, propionic acid and 2-ethylhexanoic acid.

6. A method according to claim 1, said atmosphere of water vapor has a partial pressure of water vapor which is in a range between 6 and 18 kPa.

7. A method according to claim 6, said atmosphere of water vapor consists of an inert gas and water vapor.

8. A semiconductor device comprising a thin film of metal oxide on a substrate, said thin film being produced by steps of:
coating said substrate with a solution of a metal salt of a carboxylic acid; and
heating said substrate to a predetermined temperature below 300 °C in an atmosphere of water vapor.

9. Apparatus for producing metal oxide comprising:
(a) a water vapor generator (12) for generating a water-vapor-containing gas (13) with a desired partial pressure of water vapor; and
(b) heating equipment (10) for heating a metal salt of a carboxylic acid (20) , which has been put in a sample vessel, to a predetermined temperature in a water-vapor-containing gas (13) which is introduced from said water vapor generator (12).

10. Apparatus according to claim 9, further comprising coating equipment for coating a substrate with a solution of said metal salt of said carboxylic acid.

11. Apparatus according to claim 9, wherein said heating equipment (34) is combined with a unit for X-ray diffraction analysis (42, 44) of said metal salt of said carboxylic acid (20) and its derivatives.

12. Apparatus according to claim 9, wherein said heating equipment (10) is combined with a unit for differential thermal analysis (21) of said metal salt of said carboxylic acid (20) and its derivatives.

13. Apparatus according to claim 9, wherein said heating equipment (34) is combined with a unit for differential scanning calorimetric analysis (38, 39, 40) of said metal salt of said carboxylic acid (20) and its derivatives.

14. Apparatus according to claim 9, wherein said heating equipment (10) is combined with a unit for thermogravimetric analysis (14, 16, 21) of said metal salt of said carboxylic acid (20) and its derivatives.

15. Apparatus according to claim 9, wherein said heating equipment (10) is combined with:
a unit for thermogravimetric analysis (14, 16, 21) of said metal salt of said carboxylic acid (20) and its derivatives; and
a unit for differential thermal analysis (21) or differential scanning calorimetric analysis (38, 39, 40) of said metal salt of said carboxylic acid (20) and its derivatives.

16. Apparatus according to claim 9, further comprising a constant temperature device (23) for maintaining an inner wall surface temperature of the heating equipment (10) at a desired value higher than a room temperature.
